# EUROPÄISCHE PATENTSCHRIFT

(11) **EP 2 101 182 B1**
(45) Veröffentlichungstag und Bekanntmachung des Hinweises auf die Patenterteilung: **18.10.2017**
(21) Anmeldenummer: 09001629.6
(22) Anmeldetag: 05.02.2009
(51) Int. Cl.: G01R 27/32, G01R 35/00

(54) **Anordnung zum Kalibrieren eines Vektornetzwerkanalysators**
Vector network analyser calibration system
Agencement destiné à calibrer un analyseur de réseau vecteur

(30) Priorität: 13.03.2008 DE 102008014039
(43) Veröffentlichungstag der Anmeldung: 16.09.2009
(73) Patentinhaber: Spinner GmbH, 80335 München (DE)
(72) Erfinder: Graßl, Martin, 85435 Erding (DE); Lindner, Anton, Dr., 81541 München (DE); Nagel, Reimer, Dr., 81739 München (DE); Lege, Michael, 83052 Bruckmühl (DE)
(74) Vertreter: Prietsch, Reiner

(56) Entgegenhaltungen:
- DE-A1-102005 018 073
- US-A1- 2004 150 411
- US-A1- 2006 279 298
- ANONYMOUS: "Agilent: Electronic vs. Mechanical Calibration Kits: Calibration Methods and Accuracy", , Juni 2003 (2003-06), Seiten 1-16, XP000002649200, Gefunden im Internet: URL:http://cp.literature.agilent.com/litwe b/pdf/5988-9477EN.pdf [gefunden am 2011-07-11]

## Beschreibung

Die Erfindung betrifft eine Anordnung zum Kalibrieren eines softwaregesteuerten Vektornetzwerkanalysators (VNA) durch Verbinden mindestens einer Kalibrierkomponente aus einem Satz von Kalibrierkomponenten mit dem VNA, der in einem Kalibriermodus die Kalibrierkomponente als Messobjekt behandelt, aus deren gemessenen Ist-Werten und deren in einem Speicher des VNA abgelegten charakteristischen Daten Fehlerterme berechnet und im Messmodus für angeschlossene Messobjekte entsprechend diesen Fehlertermen berichtigte Messergebnisse ausgibt.

Die Komponenten eines VNA haben einen Amplituden- und Phasengang über die Frequenz, der insbesondere bei Änderung des Messfrequenzbereiches, der Sendeamplitude und/oder der Messleitungen eine Neukalibrierung erförderlich macht. Zur Kalibrierung werden Kalibrierkomponenten mit bekannten Eigenschaften verwendet. Die unterschiedlichen Kalibrierkomponenten, von denen die häufigsten kurz mit Short, Open, Load und Through bezeichnet werden, bilden zusammen einen Kalibriersatz. Die jeweilige Kalibrierkomponente, im Folgenden auch kurz "Komponente", wird mit dem jeweiligen Messtor bzw. den Messtoren des VNA verbunden. Daran schließt sich der eigentliche, in der Regel menügeführte Kalibriervorgang an. Diese Art der Kalibrierung von Hand ist fehleranfällig durch Verwechselung von Kalibrierkomponenten.

Als Alternative stehen elektronische Kalibriermodule zur Verfügung, die die Kalibrierdaten, d.h. die charakteristischen Daten, als gespeicherte Werte enthalten und HF-mäßig mit den Messtoren sowie über eine Datenleitung mit einer Datenschnittstelle des VNA verbunden werden. Dadurch werden zwar die vielfachen (Um-)Steckvorgänge der manuellen Kalibrierung vermieden und deren Risiko einer fehlerhaften Kalibrierung deutlich vermindert, jedoch sind die Kosten solcher elektronischer Kalibriermodule sehr hoch.

US2004/150411 A1, US2006/279298 A1, DE102005018073 A1 sowie "Agilent: Electronic vs. Mechanical Calibration Kits: Calibration Methods and Accuracy" XP000002649200 offenbaren weiteren Stand der Technik zur Erklärung des Hintergrunds der Erfindung.

Der Erfindung liegt die Aufgabe zugrunde, eine Anordnung der einleitend angegebenen Gattung zur Verfügung zu stellen, die im Vergleich zu einer manuellen Kalibrierung sowohl zeitsparender als auch fehlersicherer ist und im Vergleich zu einer automatischen Kalibrierung wesentlich kostengünstiger ist.

Diese Aufgabe ist erfindungsgemäß dadurch gelöst, dass jede Kalibrierkomponente einen Transponder mit einem nichtflüchtigen Speicher umfasst, der als unveränderliche Daten mindestens die Art der Komponente sowie eine individuelle Identnummer und als veränderliche Daten mindestens die Anzahl der mit dieser Kalibrierkomponente durchgeführten Kalibriervorgänge enthält, und dass der VNA eine drahtlose Schnittstelle zum Auslesen mindestens der unveränderlichen Daten der jeweiligen Kalibrierkomponente und zum Inkrementieren der gespeicherten Anzahl der mit dieser Kalibrierkomponente durchgeführten Kalibriervorgänge hat.

Die Steuerung der Kommunikation zwischen der drahtlosen Schnittstelle des VNA und dem Transponder der jeweiligen Kalibrierkomponente besorgt der Mikroprozessor des VNA.

Beim Auslesen des Transponders einer Komponente vergleicht der Mikroprozessor die ausgelesenen unveränderlichen Daten mit den gespeicherten Daten und mit den vom Benutzer vorgenommenen Voreinstellungen des VNA oder führt diese Voreinstellungen selbsttätig aus. Die ausgelesenen veränderlichen Daten werden vom Mikroprozessor verarbeitet und auf den Transponder zurückgeschrieben. Infolge dessen sind Fehlbedienungen, z.B. eine Voreinstellung auf einen Short, jedoch der versehentliche Anschluss eines Open, die Benutzung einer nicht zugelassenen Komponente oder die Benutzung einer Komponente, deren Anzahl zulässiger Benutzungen oder deren zulässiger Benutzungszeit überschritten ist, ausgeschlossen. Infolge dessen ist die Kalibrierung mit der Anordnung gemäß der Erfindung im Vergleich zu einer üblichen, manuellen Kalibrierung sowohl zeitsparend als auch handhabungssicherer. Gleichzeitig ist sie im Vergleich zu einer automatischen Kalibrierung mittels eines komplexen elektronischen Kalibriermoduls kostengünstiger, weil sie mittels der üblichen Kalibrierkomponenten, die nur zusätzlich mit je einem entsprechenden Transponder ausgestattet oder nachgerüstet sind, durchgeführt wird.

Eine bevorzugte Ausführungsform besteht darin, dass der VNA die drahtlose Schnittstelle nach dem Auslesen der Daten der Kalibrierkomponente und dem Inkrementieren der gespeicherten Anzahl der Kalibriervorgänge abschaltet. Dadurch wird sichergestellt, dass die nur zum Erkennen der Komponente und deren Daten notwendige, in der Regel HF-mäßige Kommunikation zwischen der Schnittstelle und dem Transponder der Komponente den anschließenden, sehr störempfindlichen Kalibriervorgang nicht verfälscht.

Die drahtlose Schnittstelle kann insbesondere aus einem über eine Steckverbindung an den VNA anschließbaren, drahtlosen Lese/Schreib-Modul bestehen. Derartige Lese/Schreib-Module, die auf der Basis eines genormten Kommunikationsprotokolls, z.B. dem bei VNAs häufig schon implementierten USB-Protokoll, arbeiten, sind handelsüblich.

Die drahtlose Schnittstelle kann mit dem VNA über dessen vorhandenen Datenbus kommunizieren.

Bei den vorstehend genannten charakteristischen Daten der jeweiligen Kalibrierkomponente kann es sich um die dem Fachmann bekannten Koeffizienten, z.B. die Versatzlänge, deren Leitungsverluste, Polynomkoeffizienten der Induktivität (beim Short) oder der Kapazität (beim Open) usw. handeln. Die charakteristischen Daten können aber auch auf dem vollständigen und sehr umfangreichen Datensatz der S-Parameter der jeweiligen Kalibrierkomponente bestehen.

Grundsätzlich kann der nichtflüchtige Speicher des Transponders jeder Kalibierkomponente auch deren charakteristischen Daten enthalten, die dann über die drahtlose Schnittstelle ausgelesen und in dem Speicher des VNA zur Berechnung der Fehlerterme abgelegt werden. Wenn der Speicherplatz auf dem Transponder beschränkt ist, bestehen in diesem Fall die charakteristischen Daten aus den vorgenannten Koeffizienten. Wenn hingegen der Speicherplatz zur Aufnahme des umfangreichen S-Parameter-Datensatzes ausreicht, können die charakteristischen Daten aus diesem Datensatz bestehen.

In der Ausführungsform, bei der die drahtlose Schnittstelle aus einem an den VNA anschließbaren drahtlosen Lese/ Schreib-Modul besteht, können die charakteristischen Daten alternativ jedoch auch in einem nichtflüchtigen Speicher dieses Lese/Schreib-Moduls abgelegt sein. In diesem Fall ist das Lese/Schreib-Modul integraler Bestandteil des Satzes von Kalibrierkomponenten und enthält die charakteristischen Daten aller Kalibrierkomponenten dieses Satzes in einem nichtflüchtigen Speicher; beim Auslesen der unveränderlichen Daten einer bestimmten Kalibierkomponente werden dann mindestens auch deren charakteristischen Daten aus dem nichtflüchtigen Speicher des Lese/Schreib-Moduls ausgelesen und in dem Speicher des VNA zur Berechnung der Fehlerterme abgelegt. Diese Variante kommt folglich vor allem dann in Betracht, wenn die Kalibrierkomponenten mit preiswerten Transpondern, die nur relativ wenig Speicherplatz bieten, ausgestattet werden, der VNA jedoch mittels der S-Parameter-Datensätze und der Komponenten kalibriert werden soll.

Vorzugsweise umfasst der Mikroprozessor des VNA auch ein Programm zum Auslesen, Auswerten und Anzeigen der Daten jeder Kalibrierkomponente. Auf diese Weise kann insbesondere festgestellt werden, für wie viele weitere Kalibriervorgänge die betreffende Komponente zulässigerweise noch verwendet werden darf.

Die Anordnung nach der Erfindung wird anhand einer beispielhaft gewählten, in der Zeichnung schematisch vereinfacht dargestellten Ausführungsform und Ablaufdiagrammen erläutert. Es zeigt:
- Fig. 1: einen Vektornetzwerkanalysator (VNA)
- Fig. 2: ein Blockschaltbild des Meßsystems des VNA
- Fig. 3: einen Kalibriersatz und, vergrößert, dessen Lese/Schreib-Modul und eine Kalibrierkomponente
- Fig. 4: ein Ablaufdiagramm für einen Kalibriervorgang
- Fig. 5: ein Ablaufdiagramm zur Erzeugung eines Statistikprotokolls einer Komponente

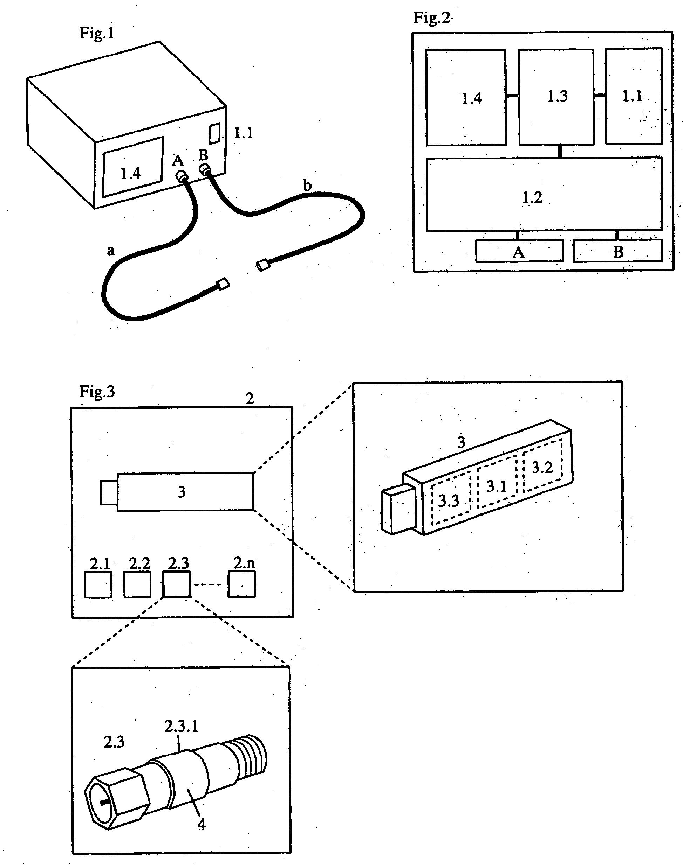

Der in Fig. 1 dargestellte, übliche VNA 1, dessen Bedienelemente auf der Frontseite weggelassen sind, hat ein Messtor A mit angeschlossener Messleitung a und ein Messtor B mit angeschlossener Messleitung b. An die Steckverbindungen am Ende der Messleitungen a und b werden im Kalibrierzyklus zunächst die verschiedenen Kalibrierkomponenten und, nach erfolgter Kalibrierung, die jeweiligen Messobjekte angeschlossen. Der VNA 1 hat des weiteren eine Datenschnittstelle 1.1, z.B. in Form eines USB-Anschlusses.

Fig. 2 ist ein vereinfachtes Blockschaltbild des grundsätzlich bekannten Aufbaus eines VNAs. Die Messtore A und B dienen zur Verbindung der Messobjekte der im Rahmen der Erfindung nicht näher interessierenden, komplexen Messschaltung 1.2, die von einem Mikroprozessor 1.3 gesteuert wird, der sowohl mit der auch in Fig. 1 angedeuteten Bildschirmanzeige als auch mit der Schnittstelle 1.1 verbunden ist.

Fig. 3 zeigt einen Kalibriersatz 2, der neben den an sich bekannten Kalibrierkomponenten 2.1, 2.2, 2.3 bis 2.n ein Lese/Schreib-Modul 3 umfasst. In Figur 3 zeigt nur einen Teil der erfindungsgemäßen Anordnung zum Kalibrieren. Insbesondere der VNA ist nicht dargestellt. Das Lese/Schreib-Modul 3 hat (beispielhaft) die Form eines üblichen USB-Sticks mit einer üblichen Kommunikationsschaltung (nicht dargestellt), einem von dem VNA aus abschaltbaren Sender/Empfänger 3.1 kurzer Reichweite mit darauf abgestimmter Antenne 3.2 z. B. nach Art einer Rahmenantenne, und ggf. einem nichtflüchtigem Speicher 3.3, in dem je nach Ausführungsform die Identnummern aller Kalibrierkomponenten 2.1 bis 2.n, deren charakteristischen Daten und eine Identnummer des Kalibriersatzes 2 gespeichert sind.

Alle Kalibrierkomponenten 2.1 bis 2.n unterscheiden sich von den entsprechenden, bekannten Kalibrierkomponenten nur durch die zusätzliche Ausstattung mit einem Transponder, der z.B. in Form eines RFID-Transponders 4 unlösbar an der Komponente befestigt und nötigenfalls zusätzlich mit einer Antenne verbunden sein kann. Im Beispiel ist angenommen, dass es sich bei der Komponente 2.3 um einen Through handelt. Letzterer ist von einer Hülse 2.3.1 umschlossen, in die ein RFID-Transponder 4 eingebettet ist, der mit mehreren, ebenfalls in die Hülse 2.3.1 eingebetteten Drahtwindungen als Antenne verbunden ist (nicht dargestellt). Der RFID-Transponder 4 enthält einen Speicherchip, der als nichtflüchtiger Speicher ausgeführt ist und einen Bereich für eine unveränderliche Identnummer, einen Bereich für die Art der Komponente und einen Bereich für die unveränderlichen Kalibrierdaten hat. Außerdem enthält der Speicherchip einen beschreibbaren Bereich, der als Zykluszähler dient, nämlich bei jeder Verwendung der Komponente durch das Lese/Schreib-Modul 3 um eine Einheit hoch gesetzt wird.

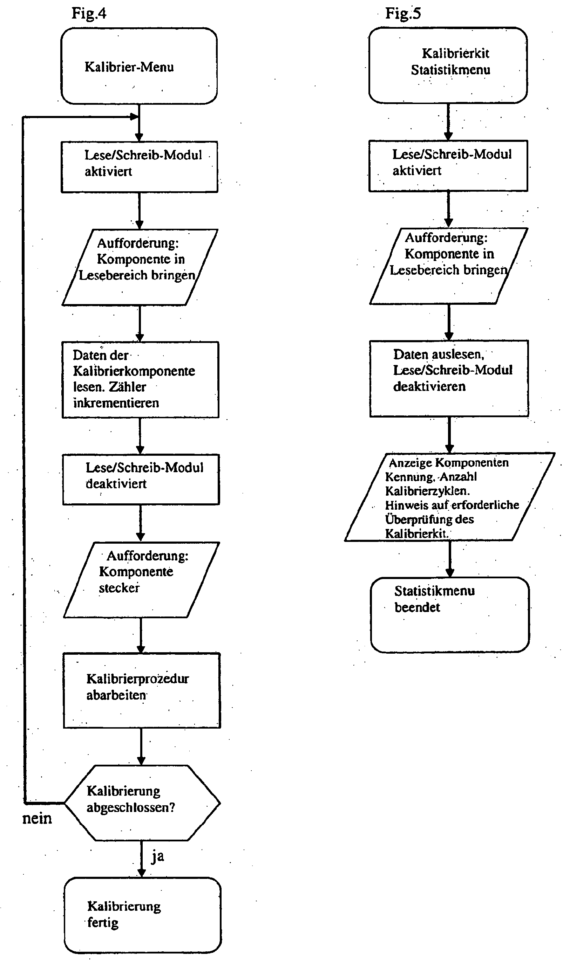

Fig. 4 veranschaulicht den Ablauf eines Kalibierzyklus. Der Schritt 2 "Komponente in Lesebereich bringen" hat seinen Grund darin, dass die Reichweite der HF-Verbindung zwischen dem mit dem VNA 1 verbundenen Lese/Schreib-Modul 3 und dem Transponder 4 der jeweiligen Komponente bewusst auf wenige Zentimeter beschränkt ist, um die Einstrahlung von HF-Störungen auf unmittelbar benachbarte Messplätze zu minimieren und um ein gleichzeitiges Auslesen von mehreren Komponenten zu vermeiden. Besonders wichtig ist des weiteren der Schritt "Lese/Schreib-Modul desaktivieren", denn ohne diesen Schritt bestünde das Risiko, dass die HF-Kommunikationsverbindung den Kalibriervorgang verfälscht, ohne dass dies für den Benutzer erkennbar wäre Fig. 5 veranschaulicht die Generierung eines komponentenbezogenen Statistikberichtes.

## Patentansprüche

1. Anordnung, bestehend aus einem softwaregesteuerten Vektornetzwerkanalysator VNA und einem Satz (2) von Kalibrierkomponenten zum Kalibrieren des softwaregesteuerten Vektornetzwerkanalysators durch Verbinden mindestens einer Kalibrierkomponente (2.1 bis 2.n) aus dem Satz (2) von Kalibrierkomponenten mit dem VNA, wobei der VNA Mittel aufweist um in einem Kalibriermodus die Kalibrierkomponente als Messobjekt zu behandeln, aus deren gemessenen Ist-Werten und deren in einem Speicher des VNA abgelegten charakteristischen Daten Fehlerterme zu berechnen und in einem Messmodus für angeschlossene Messobjekte entsprechend diesen Fehlertermen berichtigte Messergebnisse auszugeben, **dadurch gekennzeichnet, dass** jede Kalibrierkomponente (2.1 bis 2.n) einen Transponder (4) mit einem nichtflüchtigen Speicher umfasst, der als unveränderliche Daten mindestens die Art der Kalibrierkomponente sowie eine individuelle Identnummer und als veränderliche Daten mindestens die Anzahl der mit dieser Kalibrierkomponente durchgeführten Kalibriervorgänge enthält, und dass der VNA eine drahtlose Schnittstelle (1.1, 3) und Mittel zum Auslesen mindestens der unveränderlichen Daten der jeweiligen Kalibrierkomponente und zum Inkrementieren der gespeicherten Anzahl der mit dieser Kalibrierkomponente durchgeführten Kalibriervorgänge hat.

2. Anordnung nach Anspruch 1, **dadurch gekennzeichnet, dass** der VNA Mittel umfasst um die drahtlose Schnittstelle (1.1, 3) nach dem Auslesen der Daten der Kalibrierkomponente und dem Inkrementieren der gespeicherten Anzahl der Kalibriervorgänge abschaltet.

3. Anordnung nach Anspruch 1 oder 2, **dadurch gekennzeichnet, dass** die drahtlose Schnittstelle aus einem über eine Steckverbindung (1.1) an den VNA anschließbaren drahtlosen Lese/Schreib-Modul (3) besteht.

4. Anordnung nach einem der Ansprüche 1 bis 3, **dadurch gekennzeichnet, dass** die drahtlose Schnittstelle (1.1, 3) Mittel umfasst um mit dem VNA über dessen Datenbus zu kommunizieren.

5. Anordnung nach einem der Ansprüche 1 bis 4, **dadurch gekennzeichnet, dass** der nichtflüchtige Speicher des Transponders (4) jeder Kalibrierkomponente (2.1 bis 2.n) auch deren charakteristische Daten enthält und die Anordnung Mittel umfasst, um die charakteristischen Daten über die drahtlose Schnittstelle (1.1, 3) auszulesen und in dem Speicher des VNA zur Berechnung der Fehlerterme abzulegen.

6. Anordnung nach Anspruch 3 oder 4, **dadurch gekennzeichnet, dass** der Lese/Schreib-Modul (3) integraler Bestandteil des Satzes (2) von Kalibrierkomponenten ist und die charakteristischen Daten aller Kalibrierkomponenten dieses Satzes (2) in einem nichtflüchtigen Speicher (3.3) enthält, und die Anordnung Mittel umfasst um beim Auslesen der unveränderlichen Daten einer bestimmten Kalibrierkomponente mindestens auch deren charakteristische Daten aus dem nichtflüchtigen Speichers der Lese/Schreib-Moduls (3) auszulosen und in dem Speicher des VNA zur Berechnung der Fehlerterme bzulegen.

7. Anordnung nach einem der Ansprüche 1 bis 6, **dadurch gekennzeichnet, dass** der VNA ein Programm zum Auslesen, Auswerten und Anzeigen der Daten jeder Kalibrierkomponente umfasst.

## Claims

1. Arrangement consisting of a software-controlled vector network analyser VNA and a set (2) of calibration components for calibrating the software-controlled vector network analyser by connecting at least one calibration component (2.1 to 2.n) from the set (2) of calibration components to the VNA, the VNA comprising means for treating the calibration components as a measuring object in a calibration mode, for calculating error terms from actual measured values of said calibration components and from characteristic data of said calibration components saved to a memory of the VNA, and, in a measuring mode, for outputting measuring results which are corrected for connected measuring objects according to said error terms, **characterised in that** each calibration component (2.1 to 2.n) comprises a transponder (4) having a non-volatile memory which contains, as non-changeable data, at least the type of calibration component and an individual identification number and, as changeable data, at least the number of calibration processes performed using said calibration component, and **in that** the VNA has a wireless interface (1.1, 3) and means for reading out at least the non-changeable data of the relevant calibration component and for incrementing the stored number of calibration processes performed using said calibration component.

2. Arrangement according to claim 1, **characterised in that** the VNA comprises means for switching off the wireless interface (1.1,3) after the data of the calibration component has been read out and the stored number of calibration processes has been incremented.

3. Arrangement according to either claim 1 or claim 2, **characterised in that** the wireless interface consists of a wireless read/write module (3) that can be connected to the VNA via a plug-in connection (1.1).

4. Arrangement according to any of claims 1 to 3, **characterised in that** the wireless interface (1.1,3) comprises means for communicating with the VNA via the data bus thereof.

5. Arrangement according to any of claims 1 to 4, **characterised in that** the non-volatile memory of the transponder (4) of each calibration component (2.1 to 2.n) also contains the characteristic data thereof and the arrangement comprises means for reading out the characteristic data via the wireless interface (1.1, 3) and for saving said characteristic data to the memory of the VNA in order to calculate the error terms.

6. Arrangement according to either claim 3 or claim 4, **characterised in that** the read/write module (3) is an integral constituent of the block (2) of calibration components and contains the characteristic data of all the calibration components of said set (2) in a non-volatile memory (3.3), and the arrangement comprises means for reading out in addition at least the characteristic data of a particular calibration component from the non-volatile memory of the read/write module (3) while the non-changeable data of said calibration component are being read out, and for saving said characteristic data to the memory of the VNA in order to calculate the error terms.

7. Arrangement according to any of claims 1 to 6, **characterised in that** the VNA comprises a program for reading out, evaluating and displaying the data of each calibration component.

## Revendications

1. Agencement destiné à calibrer un analyseur de réseau vecteur commandé par logiciel (VNA) en reliant au moins un composant de calibrage (2.1 à 2.n) d'un ensemble de composants de calibrage au VNA, qui dans un mode de calibrage traite le composant de calibrage comme objet de mesure, qui calcule à partir de ses valeurs réelles mesurées et de ses données caractéristiques stockées dans une mémoire du VNA des termes de défauts et qui dans le mode de mesure produit pour des objets de mesure raccordés des résultats de mesure corrigés selon ces termes de défauts, **caractérisé en ce que** chaque composant de calibrage (2.1 à 2.n) comprend un transpondeur (4) avec une mémoire non volatile, qui contient comme données invariables au moins la nature du composant ainsi qu'un numéro d'identification individuel et comme données variables au moins le nombre des opérations de calibrage effectuées avec ce composant de calibrage, et **en ce que** le VNA comporte une interface sans fil (1.1, 3) pour lire au moins les données invariables du composant de calibrage respectif et pour incrémenter le nombre mémorisé des opérations de calibrage effectuées avec ce composant de calibrage.

2. Agencement selon la revendication 1, **caractérisé en ce que** le VNA déconnecte l'interface sans fil (1.1, 3) après la lecture des données du composant de calibrage et l'incrémentation du nombre mémorisé des opérations de calibrage.

3. Agencement selon la revendication 1 ou 2, **caractérisé en ce que** l'interface sans fil se compose d'un module de lecture/écriture sans fil (3) pouvant être raccordé au VNA au moyen d'une liaison par connecteur (1.1).

4. Agencement selon l'une quelconque des revendications 1 à 3, **caractérisé en ce que** l'interface sans fil (1.1, 3) communique avec le VNA par l'intermédiaire de son bus de données.

5. Agencement selon l'une quelconque des revendications 1 à 4, **caractérisé en ce que** la mémoire non volatile du transpondeur (4) de chaque composant de calibrage (2.1 à 2.n) contient aussi ses données caractéristiques et **en ce que** ces dernières sont lues et sont stockées dans la mémoire du VNA par l'intermédiaire de l'interface sans fil (1.1, 3) pour le calcul des termes de défauts.

6. Agencement selon la revendication 3 ou 4, **caractérisé en ce que** le module de lecture/écriture (3) fait partie intégrante de l'ensemble (2) de composants de calibrage et contient les données caractéristiques de tous les composants de calibrage de cet ensemble (2) dans une mémoire non volatile (3.3), et **en ce que** lors de la lecture des données invariables d'un composant de calibrage déterminé on lit au moins aussi ses données caractéristiques à partir de la mémoire non volatile du module de lecture/écriture (3) et on les stocke dans la mémoire du VNA pour le calcul des termes de défauts.

7. Agencement selon l'une quelconque des revendications 1 à 6, **caractérisé en ce que** le VNA comprend un programme permettant de lire, d'analyser et d'afficher les données de chaque composant de calibrage.
